# EUROPÄISCHE PATENTANMELDUNG

(11) **EP 1 355 520 A2**
(43) Veröffentlichungstag der Anmeldung: **22.10.2003**
(21) Anmeldenummer: 03014931.4
(22) Anmeldetag: 05.07.1999
(51) Int. Cl.: H05K 3/02

(54) **Verfahren zur Verbindung von Kupferfolien und Trennblechen bzw. Trennblech für das Laminieren von Mehrlagenleiterplatten-Presspaketen**

(30) Priorität: 14.07.1998 DE 19831461
(62) Teilanmeldung aus: 99961990.1
(71) Anmelder: Backhaus, Dieter, 79350 Sexau (DE)
(72) Erfinder: Backhaus, Dieter, 79350 Sexau (DE)
(74) Vertreter: Hübsch, Dirk, Dipl.-Ing.

(57) **Zusammenfassung**

Die Erfindung betrifft ein Verfahren zur partiellen Verbindung von Kupferfolien beliebiger Art und Dicke mit Trennblechen, insbesondere Aluminium-Pressblechen, beliebiger Art und Dicke, die beim Laminieren von Mehrlagenleiterplatten-Presspaketen vorgesehen werden, durch
- beidseitiges Auflegen der Kupferfolien auf das Trennblech, wobei die Abmessungen der Kupferfolien größer als die des Trennbleches sind, so dass diese allseitig über das Trennblech hinausragen und eng an diesem anliegen und
stoffschlüssiges Verbinden der überstehenden Kupferfolien derart, dass zwischen dem Trennblech und den Verbindungsstellen ein Freiraum - zur Aufnahme der thermisch bedingten Ausdehnung des Trennbleches - verbleibt.

## Beschreibung

Die Erfindung betrifft ein Verfahren zur Verbindung von Kupferfolien und Trennblechen für die Verpressung von mehrlagigen Leiterplatten bzw. ein Trennblech für das Laminieren von Mehrlagenleiterplatten-Presspakten, vzw. hergestellt nach dem eingangs genannten Verfahren.

Bekannt ist, dass die beiden Außenlagen einer mehrlagigen Leiterplatte mit ganzflächigen Kupferfolien ausgerüstet sind, die beim Laminiervorgang mit Hilfe der darunterliegenden Prepreg-Schicht (ein mit Epoxydharz getränktes Glasfasergewebe) auf das jeweilige Paket auflaminiert werden. Aus diesen Folien wird dann das Endleiterbild geätzt. Die Kupferfolie muß dabei frei von Eindrücken, Kratzern oder Erhebungen sein. Diese Gleichmäßigkeit erreicht man, wenn Trennbleche mit einer glatten Oberfläche eingesetzt werden. So können auch mehrere Lagen gleichzeitig verpresst werden.

Die Verpressung der Leiterplatten erfolgt in Etagen- oder Vakuumpressen, wobei die Kupferfolie unter Druck und Erhitzung auf ca. 180 Grad Celsius mit dem Prepreg verpresst wird und anschließend mit dem Paket der Innenlagen einen untrennbaren Verbund bildet.

Nach DE 38 44 498 A1 soll ein Verzug der verpressten Multilayerpakete und damit eine unebene Kupferoberfläche dadurch vermieden werden, dass das Verpressen durch Vakuumanwendung und isostatische Presstechnik erfolgt. Dabei werden zusätzliche Platten, schwimmend gelagert und thermisch isoliert, eingeführt, die bei der Erwärmung des Multilayerpaketes die Pressplatten kühl halten.

Nachteil dieses Verfahrens ist es, dass sich auf jeder Werkzeugplatte ein Paket gleicher Fläche und Dicke befinden muß, so dass das bei der Erhitzung austretende Epoxydharz die Kanten des Mulitlayers verkleben kann.

Nach DE 35 07 568 C2 soll zwar ein Verrutschen der Prepreg-Lagen durch eine Rutschsicherung vermieden werden, was einen möglichen Austritt des Prepregs an den Paketseiten jedoch nur dann verhindern kann, wenn die Kupferfolien etwas größer als die anderen Lagen gewählt werden, so dass das Prepreg daran ablaufen kann. Nachteil hierbei ist, dass Edelstahl die Wärme schlecht leitet, weshalb eine längere Erwärmungszeit nötig ist. Auch ist die Wärmedurchdringung ungleichmäßiger als z.B. bei Aluminiumblechen.

Das Verfahren nach DE 41 16 543 A1 verwendet ein Stahltrennblech mit einem auf 16 10 6 pro Grad Celsius erhöhten Wärmeausdehnungskoeffizienten, der dadurch dem Ausdehnungskoeffizienten des Kupfers angenähert ist. Hierdurch wird zwar eine Oberflächenspannung weitestgehend vermieden, die Erwärmungszeit für das Edelstahlblech bleibt jedoch gleich hoch.

Immer häufiger werden deshalb statt Stahl- Aluminiumbleche verwendet, die die Wärme besser und gleichmäßiger leiten können.

Weiterhin müssen bei allen oben genannten Verfahren die Kupferfolie und das entsprechende Trennblech mit den anderen Lagen in einem Legeraum durch speziell geschultes Personal von Hand zu einem Paket zusammengefügt werden (vgl. Manfred Huschka, "Einführung in die Mulitlayer-Preßtechnik" Eugen G. Leuze Verlag, 1988, Kapitel 3). Die oft sehr dünnen und daher empfindlichen Kupferfolien können dabei schnell zerdrückt werden.

Das Verfahren nach DE 31 31 688 A1 beschreibt lediglich die Herstellung eines Aluminiumblech-Kupferverbundes. Ein separates Handhaben von Kupferfolien wird darin jedoch nicht angesprochen.

Bei dem nachfolgenden Laminiervorgang besteht weiterhin die Gefahr, dass aufgrund der Verklebung, wegen des unterschiedlichen Wärmeausdehnungskoeffizienten von Kupfer und Aluminium größere Oberflächenspannungen entstehen. Aluminium dehnt sich schon sehr viel früher aus, als das Kupfer. Zudem kann es auch hier nach Auflösung des Epoxydharzes zu Verklebungen an den Rändern des Paketes kommen.

Auch das Verfahren nach dem U.S. Patent 5.160.567 befaßt sich mit der Herstellung von Laminaten. Dabei werden die Pressbleche beidseitig mit überstehender Kupferfolie belegt, wobei die Kupferfolien dann im Randbereich des Pressbieches miteinander verbunden werden.

Nachteilig wirkt sich hierbei die Verwendung des Edelstahlbleches aus, da die Wärme schlechter geleitet wird, als bei Aluminiumblechen und somit länger erwärmt werden muß. Zudem muß auch hier die Kupferfolie separat aufgelegt werden, was bei entsprechend dünner Folie nur schwer ohne Verdrückungen möglich ist.

Der Erfindung liegt daher die Aufgabe zugrunde, ein Verfahren bzw. ein Trennblech zu entwickeln, dass sowohl eine Verklebung von Presslagen als auch eine Deformierung der Kupferfolie in verschiedenen Arbeitsgängen verhindert bzw. weitestgehend vermeidet.

Diese Aufgabe wird erfindungsgemäß durch die Merkmale des Patentanspruches 1 bzw. durch die Merkmale des Patentanspruches 8 gelöst.

Durch diese Maßnahme wird erreicht, dass beim Legen des Presspaketes die Kupferfolie nicht mehr separat angefasst und eventuell dabei verknickt wird. Die Folie bleibt flach über das Blech gespannt, weswegen auch sehr dünne Kupferfolien gewählt werden können. Wenn direkt nach dem Einfassen Positionslöcher eingestanzt werden, so wird damit vermieden, dass bei einem weiteren Arbeitsgang, nämlich Stanzen der Positionslöcher, Verschiebungen und Beschädigungen an der Kupferfolie entstehen können.

Für die Vorbereitung des Multilayer-Preßvorganges muß dann nur noch in einem Arbeitsgang das mit den Kupferfolien bespannte und mit Registrierlöchern versehene Blech, insbesondere Aluminiumblech auf das Prepreg gelegt werden.

Während des Pressvorganges kann sich das Blech ungehindert ausdehnen und unter Umständen die Kupferfolienverbindung durchbrechen, ohne Oberflächenspannungen auf dem Kupfer hervorzurufen. Sobald das Epoxydharz unter dem Kupfer auseinanderfließt, kann es an der überstehenden Kupferfolie entlanglaufen, ohne mit dem Blech in Verbindung zu geraten. Der überstehende Rand der Kupferfolien mit den Kleberesten kann dann am Rand des Bleches, insbesondere Aluminiumbleches und damit außerhalb der Nutzfläche abgetrennt werden.

Eine mechanische Verbindung der Kupferfolien z.B. durch Verstanzen oder Prägen, ermöglicht dabei eine ungehinderte Ausdehnung des Bleches, so dass sich das austretende Harz besser verteilen kann, weil auf der Fläche keine Spannungen mehr bestehen.

Eine Verklebung des überstehenden Kupferrandes sichert über längere Zeit die Verbindung, so dass die mit Kupfer überspannten Trennbleche über einen größeren Zeitraum gelagert werden können.

Eine thermische Verbindung der Kupferfolien, wie z.B. Löten oder Schweißen ermöglicht ebenfalls die ungehinderte Ausdehnung des Bleches. Welche Form der Verbindung gewählt wird, hängt entscheidend von den Kosten dafür ab.

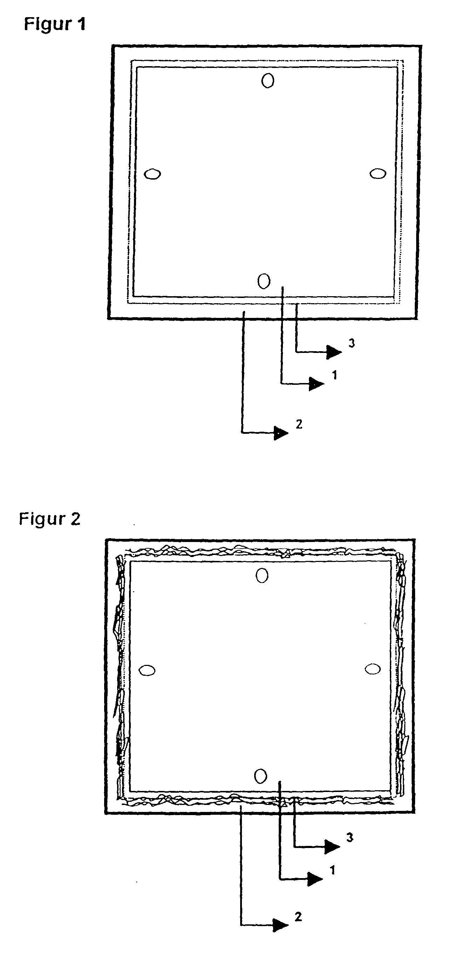

Anhand der Figuren 1 und 2 wird das Ausführungsbeispiel näher erläutert.

Die Figur 1 zeigt ein mit Positionslöchern versehenes (Aluminium-)Trennblech einer bestimmten Größe 1, welches von beiden Seiten mit einer größer gewählten Kupferfolie bedeckt ist 2. Die Verbindung der Kupferfolien erfolgt dann an einer Stelle außerhalb der Fläche des Trennbleches, so dass aber noch etwas Kupferfolie übersteht 3.

Bei Figur 2 ist das mit den Kupferfolien beidseitig bespannte Trennblech nach der Verpressung zu sehen. Das ausgedehnte Blech, insbesondere Aluminiumblech hat die Verbindung durchbrochen 1. Die Kupferfolie darunter ist im Bereich der Nutzenfläche glatt mit den Innenlagen verpresst 2. Das ausgelaufene Epoxydharz klebt an dem überstehenden Rand der Kupferfolie 3.

Es handelt sich insoweit um einen neuen Verbundwerkstoff, der den Eigenschaften der einzelnen Komponenten, bessere Wärmeleitfähigkeit und stark abweichende Wärmeausdehnungskoeffizienten Rechnung trägt.

## Patentansprüche

1. Verfahren zur partiellen Verbindung von Kupferfolien beliebiger Art und Dicke mit Trennblechen, insbesondere Aluminium-Pressblechen, beliebiger Art und Dicke, die beim Laminieren von Mehrlagenleiterplatten-Presspaketen vorgesehen werden, vzw. zur Herstellung eines Trennbleches nach einem der Ansprüche 8 bis 14 durch
- beidseitiges Auflegen der Kupferfolien auf das Trennblech, wobei die Abmessungen der Kupferfolien größer als die des Trennbleches sind, so dass diese allseitig über das Trennblech hinausragen und eng an diesem anliegen und
- stoffschlüssiges Verbinden der überstehenden Kupferfolien derart, dass zwischen dem Trennblech und den Verbindungsstellen ein Freiraum - zur Aufnahme der thermisch bedingten Ausdehnung des Trennbleches - verbleibt.

2. Verfahren nach Anspruch 1, **dadurch gekennzeichnet, dass** Positionslöcher eingebracht werden.

3. Verfahren nach einem der vorstehenden Ansprüche, **dadurch gekennzeichnet, dass** die Positionslöcher gleichzeitig mit dem stoffschlüssigen Verbinden der Kupferfolien eingebracht werden.

4. Verfahren nach einem der Ansprüche 1 oder 2, **dadurch gekennzeichnet, dass** die Positionslöcher nach dem Einfassen der Kupferfolien eingebracht werden.

5. Verfahren nach einem der vorstehenden Ansprüche, **dadurch gekennzeichnet, dass** die Kupferfolien miteinander verklebt werden.

6. Verfahren nach einem der vorstehenden Ansprüche, **dadurch gekennzeichnet, dass** die Kupferfolien durch Löten oder Schweißen miteinander verbunden werden.

7. Verfahren nach einem der vorstehenden Ansprüche, **dadurch gekennzeichnet**, das Trennblech als Aluminium-Pressblech ausgeführt wird.

8. Trennblech für das Laminieren von Mehrlagenleiterplatten-Presspakete, vzw. hergestellt nach dem Verfahren gemäß einer der Ansprüche 1 bis 7, wobei das Trennblech, insbesondere ein Aluminium-Pressblech, beliebiger Art und Dicke mit Kupferfolien versehen ist, wobei die Kupferfolien beidseitig auf das Trennblech aufgelegt sind und die Abmessungen der Kupferfolien größer als die des Trennbleches sind, so dass die Kupferfolien allseitig über das Trennblech hinausragend ausgebildet sind und wobei die überstehenden Kupferfolien derart stoffschlüssig verbunden sind, dass zwischen dem Trennblech und den Verbindungsstellen ein Freiraum - zur Aufnahme der thermisch bedingten Ausdehnung des Trennbleches - ausgebildet ist.

9. Trennblech nach Anspruch 8, **dadurch gekennzeichnet, dass** Positionslöcher eingebracht sind und die Kupferfolien eng an dem Trennblech anliegend ausgebildet sind.

10. Trennblech nach einem der Ansprüche 8 und 9, **dadurch gekennzeichnet, dass** die Positionslöcher gleichzeitig mit dem stoffschlüssigen Verbinden der Kupferfolien eingebracht sind.

11. Trennblech nach einem der Ansprüche 8 oder 9, **dadurch gekennzeichnet, dass** die Positionslöcher nach dem Einfassen der Kupferfolien eingebracht sind.

12. Trennblech nach einem der vorstehenden Ansprüche, **dadurch gekennzeichnet, dass** die Kupferfolien miteinander verklebt sind.

13. Trennblech nach einem der vorstehenden Ansprüche, **dadurch gekennzeichnet, dass** die Kupferfolien durch Löten oder Schweißen miteinander verbunden sind.

14. Trennblech nach einem der vorstehenden Ansprüche, **dadurch gekennzeichnet**, das Trennblech als Aluminium-Pressblech ausgeführt ist.
